(19) Europäisches Patentamt
European Patent Office
Office européen des brevets

(11) **EP 0 843 362 A1**

(12) **EUROPEAN PATENT APPLICATION**

(43) Date of publication:
20.05.1998 Bulletin 1998/21

(51) Int. Cl.$^6$: **H01L 31/0232**

(21) Application number: 97119355.2

(22) Date of filing: 05.11.1997

(84) Designated Contracting States:
AT BE CH DE DK ES FI FR GB GR IE IT LI LU MC NL PT SE
Designated Extension States:
AL LT LV MK RO SI

(30) Priority: 19.11.1996 JP 307952/96

(71) Applicant: NEC CORPORATION
Tokyo (JP)

(72) Inventor: Murakami, Ichiro
Minato-ku, Tokyo (JP)

(74) Representative:
Glawe, Delfs, Moll & Partner
Patentanwälte
Postfach 26 01 62
80058 München (DE)

(54) **Solid state imaging device having a microlens array covered by a reflection preventing film**

(57) A solid state imaging device of the present invention includes a light receiving unit formed on a semiconductor substrate (10), a micro lens array unit (24) formed on the light receiving unit, and a reflection preventing film (26) formed on a surface of the micro lens by vacuum vapor deposition or a like method, made of aluminum fluoride and having a film thickness ranging from 64.8 nm to 148 nm. The reflection preventing film (26) of the device of the present invention can reduce the reflection factor of light when compared with a reflection preventing film of magnesium fluoride. Further, since the reflection preventing film (26) does not have deliquescence such as that of cryolite, it requires no sealing and has a superior property also as a protective film.

Fig. 3

**Description**

BACKGROUND OF THE INVENTION

1. Field of the Invention:

This invention relates to a solid state imaging device, and more particularly to a reflection preventing film on a surface of a micro lens.

2. Description of the Related Art:

In the field of optical lenses, a technique for providing a reflection preventing film of a fluorine-containing inorganic compound on a transparent resin film of an optical lens in order to prevent reflection from a surface of the optical lens is conventionally known. As materials for the reflection preventing film of a fluorine-containing inorganic compound for use with an optical lens, magnesium fluoride, aluminum fluoride, barium fluoride, lithium fluoride, calcium fluoride, cryolite and so forth are known (refer to Japanese Patent Laid-Open Application No. 242602/91).

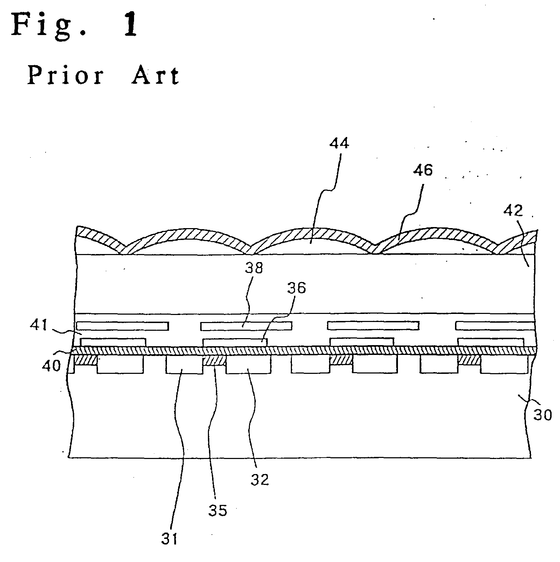

However, not all of the materials mentioned above are used for a reflection preventing film provided on a micro lens of a solid state imaging device of a CCD (charge coupled device) type. As materials for a reflection preventing film formed on a micro lens of the CCD type, magnesium fluoride and cryolite are known (refer to Japanese Patent Laid-Open Application No. 259256/92). A sectional structure of a unit pixel of the conventional solid state imaging device of the CCD type disclosed in the document just mentioned is shown in Fig. 1.

Referring to Fig. 1, photoelectric converting elements 31, vertical CCD registers 32 and transfer gate regions 35 for reading out charge from photoelectric converting elements 31 into vertical CCD registers 32 are provided in semiconductor substrate 30. Insulating film 40 is provided on semiconductor substrate 30, and transfer electrodes 36 are provided on insulating film 40 including regions above vertical CCD registers 32. Light intercepting film 38 is provided above transfer electrodes 36 with phosphorus glass layer 41 interposed therebetween, and transparent resin layer 42 is provided on light intercepting film 38. Further, micro lens array unit 44 formed from a transparent resin layer is provided on transparent resin layer 42. Furthermore, reflection preventing film 46 made of magnesium fluoride or cryolite is provided on the surface of micro lens array unit 44. Reflection preventing film 46 is formed by vacuum vapor deposition or some other suitable process.

Since the reflection preventing film made of magnesium fluoride or cryolite is formed on the micro lens, the reflection from the surface of the micro lens is reduced comparing with that in an alternative case where no reflection preventing film is formed on the micro lens.

Consequently, flare and ghost which appear upon imaging of an imaging object having a high brightness can be reduced to some degree.

Since magnesium fluoride or cryolite is used for the reflection preventing film on the micro lens of the conventional solid state imaging device described above, the reflection preventing film has the following problems.

In particular, where magnesium fluoride is used, since its refractive index is higher than a value of the refractive index optimum for a reflection preventing film determined by media above and below the magnesium fluoride, reflection is not reduced sufficiently. As a result, the reflection preventing film has a drawback in that ghost cannot be suppressed sufficiently.

An optimum refractive index for a reflection preventing film is described in detail below. It is assumed that a reflection preventing film having a refractive index $n_1$ is provided on a micro lens of another refractive index $n_2$ and the air having a further refractive index $n_0$ is present above the reflection preventing film. In this instance, the reflection factor exhibits its lowest value when

$$n_1 = (n_0 \, n_2)^{1/2}$$

irrespective of the wavelength and the incident angle of incident light. The micro lens below the reflection preventing film is usually formed from a transparent resin film, whose refractive index $n_2$ is at least within the range of 1.35 to 1.70, and the refractive index $n_0$ of the air is 1. From those facts, the optically optimum refractive index for a reflection preventing film for use with a resin layer ranges from 1.16 to 1.30. Since the refractive index of magnesium fluoride is 1.38, this is a higher value than the optically optimum refractive index for a reflection preventing film, and when compared with an optically optimum reflection preventing film, sufficient reduction of reflection is not achieved.

On the other hand, when cryolite is used, the reflection factor of it is 1.338, which is nearer to the optimum value mentioned above than that of magnesium fluoride. Therefore, where a reflection preventing film made of cryolite is provided on a micro lens formed from a transparent resin film, the reflection factor at the surface of the micro lens is lower than that when magnesium fluoride is used for the reflection preventing film, and flare and ghost can be further reduced. However, since cryolite has deliquescence, when the cryolite contacts with air containing water, it exhibits a considerable deterioration in property as a reflection preventing film. Therefore, when cryolite is used for a reflection preventing film, there is a drawback that the solid state imaging device must be sealed to assure a high airtightness so that the solid state imaging device may not contact with air containing water.

Further, where a reflection preventing film made of a fluorine containing inorganic compound is formed on a micro lens, problems peculiar to semiconductors arise. Specifically:

the first problem resides in that, if a metal element mixes into silicon when a reflection preventing film is vapor deposited or in a like case, it becomes a cause of leak current and the yield may possibly be deteriorated. This arises from the fact that the metal element produces an intermediate level in a forbidden band of silicon and is liable to form centers of generation-recombination of carriers via the level. From this fact, a metal element of a deeper level is more liable to contribute to generation of leak current.

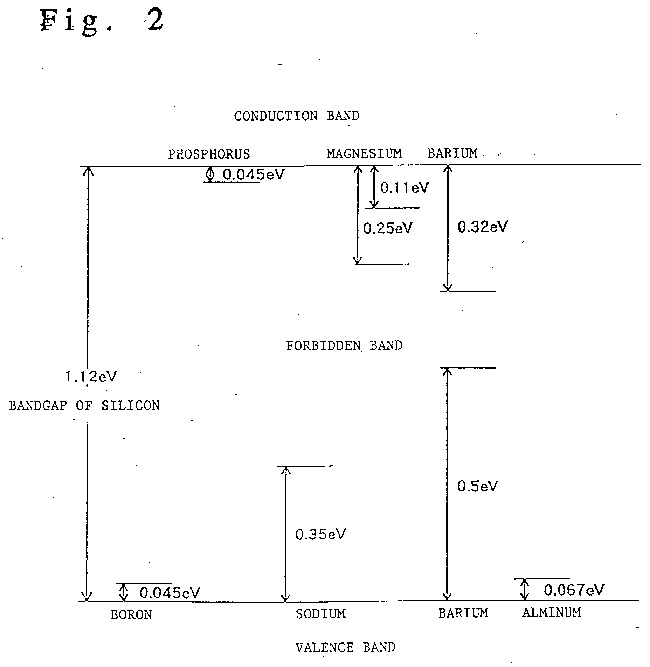

Fig. 2 illustrates levels of barium, soium, magnesium and aluminum in a forbidden band of silicon. From Fig. 2, it can be seen that the levels of sodium (sodium is contained in cryolite $Na_3[AlF_6]$), barium and magnesium are considerably deeper in level than phosphorus or boron which is used in an ordinary silicon process. From this fact, where cryolite, magnesium fluoride or barium fluoride is used for a reflection preventing film, there is a drawback that it may become a cause of generation of leak current.

The second problem resides in that, since magnesium fluoride and cryolite which are conventionally used for a reflection preventing film on a micro lens dissolve in a solvent of acid or alkali, the reflection preventing film cannot protect the device against acid or alkali.

SUMMARY OF THE INVENTION

It is an object of the present invention to provide a solid state imaging device provided with a reflection preventing film which prevents flare and ghost, has properties as a protective film in that it does not require sealing of a high airtightness and is not corroded readily by either acid or alkali and is less liable to suffer from deterioration in yield arising from a metal element in the reflection preventing film.

In a solid state imaging device of the present invention, since a reflection preventing film on a micro lens is formed of aluminum fluoride, the sensitivity is raised and flare and ghost are reduced. Further, the solid state imaging device is advantageous in that a deteriorating factor of smears which arise as part of the light entering the micro lens is multipath reflected between the surface of the micro lens and the surface of a light intercepting film or between the surface of the micro lens and the surface of silicon on photodiodes can be improved by reducing the multipath reflection.

Further, since aluminum fluoride little dissolves in solvents and is refractory to water and besides has no deliquescence, it can be used without any trouble as a reflection protecting film on a micro lens in an ordinary air atmosphere, and accordingly, it is superior also as a protective film for protecting the solid state imaging device. Furthermore, since aluminum fluoride is shallow in level in a forbidden band of silicon, it is advantageous in that it is not likely to become a cause of generation of leak current. Besides, since aluminum is a material which is universally used on a manufacture line of silicon semiconductors, there is an advantage that, even if it should pollute some other semiconductor device, the steps of washing, surface treatment and so forth can be processed by an ordinary washing method.

A solid state imaging device of the present invention wherein a micro lens is provided on a light receiving unit formed on a substrate is characterized in that a reflection preventing film made of aluminum fluoride is provided on a surface of the micro lens.

Where aluminum fluoride is provided as the reflection preventing film on the micro lens made of a transparent resin, the reflection factor of light at the surface of the micro lens can be reduced when compared with an alternative case wherein magnesium fluoride is provided as the reflection preventing film, flare and ghost upon imaging of an imaging object having a high brightness can be reduced. Further, since aluminum fluoride is free from the problem of deliquescence which occurs where cryolite is used, no particular sealing is required.

Further, while magnesium fluoride or cryolite which has conventionally been used for a reflection preventing film on a micro lens of a solid state imaging device of the CCD type does not have a property as a protective film because it dissolves in acid, since aluminum fluoride little dissolves in any other solvent than water and is refractory also to water (solubility: 0.5 gram/100 gram (25°C), where it is used for a reflection preventing film on a micro lens, it has a superior property also as a protective film for protecting the solid state imaging device.

Further, since aluminum is a material universally used for wiring lines and so forth on an ordinary manufacture line for silicon semiconductors, there is an advantage that, even if some other semiconductor device is polluted by the metal (aluminum fluoride) used for the reflection preventing film, the steps of washing, surface treatment and so forth can be processed by washing which is employed popularly (for example, Branson washing).

Furthermore, the intermediate level in a forbidden band which appears when a metal is mixed in silicon increases, as its depth increases, its mediation of movement of carriers from a valence band to a conduction band and becomes liable to be a cause of generation of leak current. When compared with sodium, magnesium and barium, the depth in level of aluminum in a forbidden band is substantially as shallow as the depth in level of phosphorus or boron. From this fact, aluminum fluoride is less liable to form centers of generation-recombination of carriers and less liable to make a cause of generation of leak current than magnesium fluoride, barium fluoride and cryolite even where it is mixed and diffused as metal atoms or ions in silicon upon vapor deposition of a reflection preventing film or the like.

The above and other object, features, and advantages of the present invention will become apparent from the following description based on the accompanying drawings which illustrate an example of a preferred embodiment of the present invention.

BRIEF DESCRIPTION OF THE DRAWINGS

Fig. 1 is a schematic sectional view showing a solid state imaging device according to the prior art;
Fig. 2 is a diagrammatic view illustrating intermediate levels of boron, phosphorus, sodium, magnesium, barium and aluminum in a forbidden band of silicon;
Fig. 3 is a schematic partial sectional view showing an embodiment of a solid state imaging device of the present invention;
Fig. 4 is a diagram illustrating an effect of a reflection preventing film of the present invention;
Fig. 5 is a diagram similar to Fig. 4; and
Fig. 6 is a diagram similar to Fig. 4.

DETAILED DESCRIPTION OF THE PREFERRED EMBODIMENT

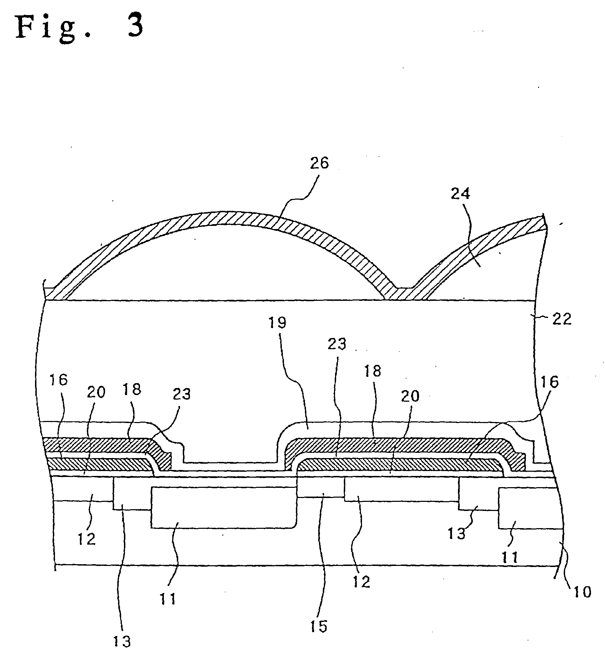

In the following, an embodiment of the present invention is described in detail with reference to the drawings. Fig. 3 is a schematic partial sectional view showing an embodiment of a solid state imaging device of the present invention.

A solid state imaging device of the present invention includes photoelectric converting elements 11, vertical CCD registers 12, transfer gate regions 15 for reading out charge from photoelectric converting elements 11 into vertical CCD registers 12, and channel stops 13 all provided on semiconductor substrate 10. Channel stops 13 are provided on photoelectric converting elements 11. Gate insulating film 20 is provided above semiconductor substrate 10, and transfer electrodes 16 are provided on gate insulating film 20 including locations above vertical CCD registers 12. Light intercepting film 18 is provided on transfer electrodes 16 with inter-layer film 23 interposed therebetween, and cover film 19 is provided on light intercepting film 18 and inter-layer film 23. Transparent resin layer 22 is provided on cover film 19, and micro lens array unit 24 is provided on transparent resin layer 22. Tungsten or aluminum may be used as a material for light intercepting film 18. Any of the following materials may be used as a material for transparent resin layer 22 or micro lens array unit 24.

* phenol-novolak type positive resist for i-ray or g-ray photo-lithography (refractive index: approximately 1.68)
* resist for deep UV photo-lithography (refractive index: approximately 1.5)
* resist for electron beam lithography (refractive index: approximately 1.5)
* water soluble resist made of casein or gelatin (refractive index: 1.5 to 1.6).

Reflection preventing film 26 made of aluminum fluoride is provided on micro lens array unit 24. The refractive index of aluminum fluoride is 1.35. Reflection preventing film 26 is formed by vacuum vapor deposition or a like method. In order to assure a high effect as a reflection preventing film against incidence of light of visible rays (wavelength: 350 nm to 800 nm), the center frequency (wavelength corresponding to the length of d/(4n) with regard to the reflection preventing film having a refractive index n and a film thickness d) preferably remains within the range from 350 nm to 800 nm. When compared with light in other wavelength regions, light of the center frequency exhibits the highest effect of reduction of the reflection factor caused by provision of the reflection preventing film. This condition corresponds, when converted into a film thickness of aluminum fluoride, to 64.8 nm to 148 nm.

In the following, the embodiment is described in more detail. In the present embodiment, transparent resin layer 22 and micro lens array unit 24 are formed so as to have a refractive index 1.68, and reflection preventing film 26 made of aluminum fluoride is provided so as to have a film thickness 102 nm (center frequency: 550 nm). Reflection preventing film 26 is formed by vacuum vapor deposition or a like method.

Next, it is described that the reflection preventing film made of aluminum fluoride described in the embodiment has a further reduced reflection factor when compared with another reflection preventing film made of magnesium fluoride having a center frequency of the same thickness.

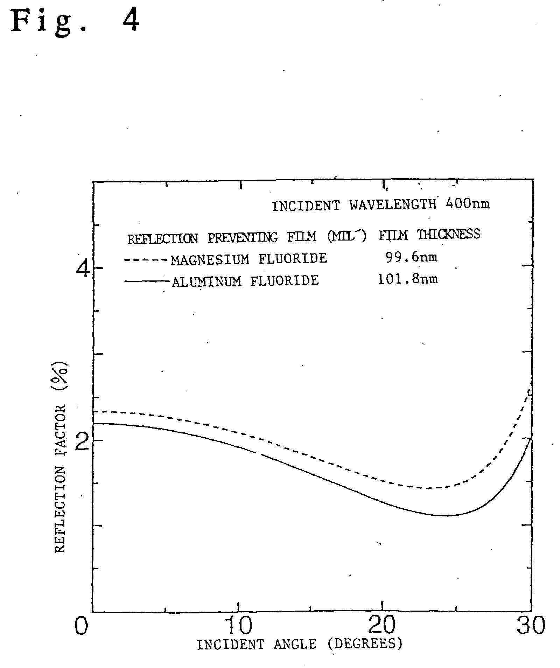

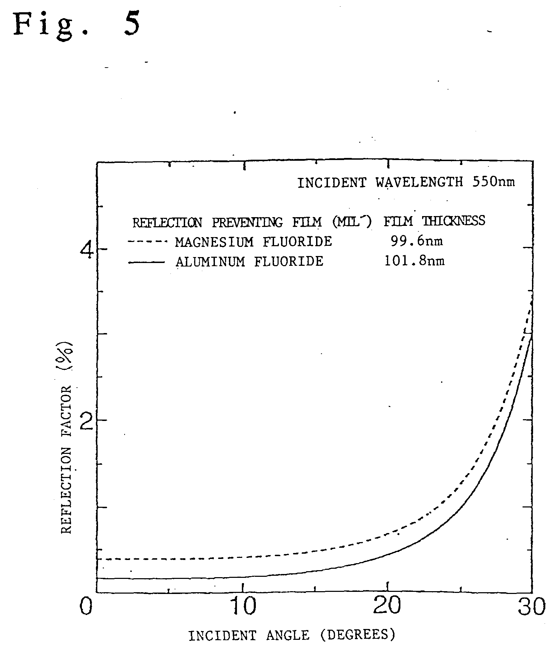

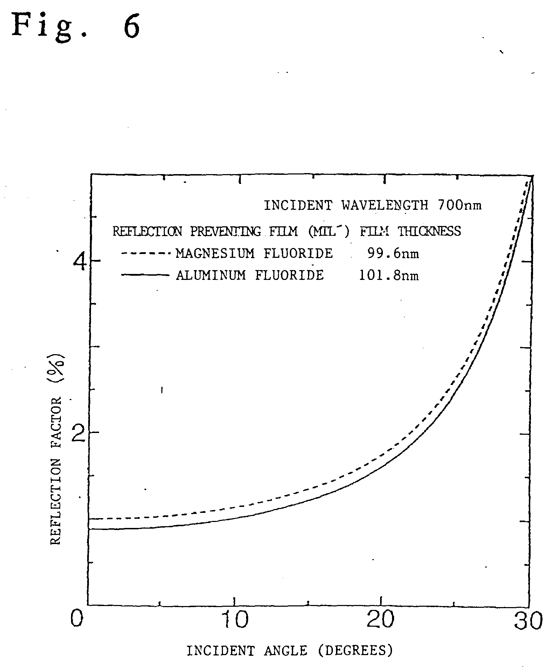

Figs. 4, 5 and 6 illustrate a result of simulation regarding the incident angle dependency of the reflection factor when lights of the wavelengths of 400 nm, 550 nm and 700 nm are introduced from above to the structure wherein a reflection preventing film of a uniform thickness is provided on a flat material having a refractive index of 1.68 and a medium having a refractive index of 1 is located above the reflection preventing film and are reflected at the interface of the reflection preventing film. As regards the effect of interference, only a phase difference which is produced in the reflection preventing film is taken into consideration, and it is assumed that the refractive index does not depend upon the wavelength. The film thickness of magnesium fluoride is set to 99.6 nm and the film thickness of aluminum fluoride is set to 101.8 nm so that the center wavelength may be 550 nm with both of the materials.

From Figs. 4, 5 and 6, it can be seen that the reflection factor when the lights of the wavelengths of 400 nm, 550 nm and 700 nm are introduced at an angle from 0 to 30 degrees are lower where the reflection preventing film is made of aluminum fluoride than where the reflection preventing film is made of magnesium fluoride.

In Figs. 4, 5 and 6, the incident angle dependencies of the reflection factor with incident lights of 400 nm, 550 nm and 700 nm in wavelength is illustrated. Where the wavelength of incident light is at least within the visible ray region (350 nm to 800 nm), in any incident angle from 0 degree to 30 degrees, the reflection factor is lower where the reflection preventing film is made of aluminum fluoride than where the reflection preventing film is made of magnesium fluoride.

Further, while, in Figs. 4, 5 and 6, a result of simulation of the incident angle dependency of the reflection factor where a reflection preventing film of a film thickness with which the center wavelength of 550 nm is obtained is indicated, where the film thickness of the reflection preventing film is 101.8 nm, if the center frequency remains at least within the range from 350 nm to 800 nm, then in any incident angle from 0 degree to 30 degrees, the reflection factor is lower when the reflection preventing film is made of aluminum fluoride than when the reflection preventing film is made of magnesium fluoride.

Further, while a result of simulation only where the reflection factor of the transparent resin film is 1.68 is indicated, in another case wherein a reflection preventing film is provided on a transparent resin film having a refractive index higher than 1.35, in an incident angle from 0 degree to 30 degrees, the reflection factor is lower when the reflection preventing film is made of aluminum fluoride than when the reflection preventing film is made of magnesium fluoride.

It is to be noted that, while the range of variation of the incident angle in Figs. 4 to 6 is 0 degree to 30 degrees, also in an incident angle larger than 30 degrees but lower than 35 degrees, the reflec tion factor is lower when the reflection preventing film is made of aluminum fluoride than when the reflection preventing film is made of magnesium fluoride.

From the foregoing, when compared with the case wherein magnesium fluoride is used for the reflection preventing film, when aluminum fluoride is used for the reflection preventing film, the reflection at the surface of a micro lens can be reduced, and accordingly, ghost and flare can be further reduced. Furthermore, since the transmission factor at the surface of the micro lens is also improved, the sensitivity is also improved.

Further, while, since part of the light introduced into the micro lens is multipath reflected between the surface of the micro lens and the surface of the light intercepting film, between the surface of the micro lens and the surface of the silicon on the photodiodes or the like, components of oblique incident light to the photodiodes increase and become a factor of deterioration in terms of smears, also the reflection factor when light advancing from the surface of the light intercepting film or the surface of the silicon toward the surface of the micro lens is reflected by the surface of the micro lens is reduced where aluminum fluoride is used for the reflection preventing film when compared with the case wherein magnesium fluoride is used for the reflection preventing film. Consequently, improvement also in regard to smears is achieved.

Since aluminum fluoride does not have deliquescence such as that of cryolite, it can be used without any trouble even if special sealing is not used.

Furthermore, aluminum fluoride little dissolves in acid and alkali. In contrast, magnesium fluoride dissolves in nitric acid and so forth. Barium fluoride dissolves in acid, aqueous ammonium chloride and so forth ("A Handbook of Chemistry, Fundamental Edition I", the Chemical Society of Japan, pp.115-118). From this, aluminum fluoride has a property as a protective film against acid and alkali.

Further, a defective level in a forbidden band which appears when a metal is mixed in silicon increases, as its depth increases, its mediation of movement of carriers from a valence band to a conduction band and becomes liable to be a cause of generation of leak current. When compared with barium fluoride, magnesium fluoride and cryolite, aluminum fluoride is less liable to become a cause of generation of leak current since it is less liable to form centers of generation-recombination of carriers even where it is mixed and diffused as metal atoms or ions in silicon upon vapor deposition of a reflection preventing film or the like.

It is to be understood, however, that although the characteristics and advantages of the present invention have been set forth in the foregoing description, the disclosure is illustrative only, and changes may be made in the arrangement of the parts within the scope of the appended claims.

## Claims

1. A solid state imaging device comprising a light receiving unit formed on a semiconductor substrate, a micro lens formed on said light receiving unit, and a reflection preventing film formed on a surface of said micro lens, characterized in that said reflection preventing film is made of aluminum fluoride.

2. The solid state imaging device as claimed in claim 1, wherein said reflection preventing film made of aluminum fluoride has a film thickness ranging from 64.8 nm to 148 nm.

# Fig. 1
Prior Art

# Fig. 2

CONDUCTION BAND

PHOSPHORUS　　　MAGNESIUM　BARIUM

0.045eV

0.11eV

0.25eV　0.32eV

FORBIDDEN BAND

1.12eV

BANDGAP OF SILICON

0.5eV

0.35eV

0.045eV　　　　　　　　　　0.067eV

BORON　　　　　SODIUM　　　BARIUM　ALMINUM

VALENCE BAND

# Fig. 3

# Fig. 4

INCIDENT WAVELENGTH 400nm

REFLECTION PREVENTING FILM (MIL') FILM THICKNESS
- - - - MAGNESIUM FLUORIDE        99.6nm
———— ALUMINUM FLUORIDE        101.8nm

REFLECTION FACTOR (%)

INCIDENT ANGLE (DEGREES)

# Fig. 5

INCIDENT WAVELENGTH 550nm

REFLECTION PREVENTING FILM (MIL⁻) FILM THICKNESS
- - - - MAGNESIUM FLUORIDE        99.6nm
——— ALUMINUM FLUORIDE       101.8nm

REFLECTION FACTOR (%)

INCIDENT ANGLE (DEGREES)

# Fig. 6

INCIDENT WAVELENGTH 700nm
REFLECTION PREVENTING FILM (MIL⁻) FILM THICKNESS
------ MAGNESIUM FLUORIDE    99.6nm
——— ALUMINUM FLUORIDE    101.8nm

REFLECTION FACTOR (%)

INCIDENT ANGLE (DEGREES)

**European Patent Office**

## EUROPEAN SEARCH REPORT

Application Number

EP 97 11 9355

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | PATENT ABSTRACTS OF JAPAN vol. 007, no. 040 (E-159), 17 February 1983 & JP 57 190455 A (NIPPON DENSHIN DENWA KOSHA), 24 November 1982, * abstract * | 1,2 | H01L31/0232 |
| A,D | PATENT ABSTRACTS OF JAPAN vol. 016, no. 032 (P-1303), 27 January 1992 & JP 03 242602 A (TORAY IND INC), 29 October 1991, * abstract * | 1,2 | |
| A,D | PATENT ABSTRACTS OF JAPAN vol. 017, no. 044 (E-1312), 27 January 1993 & JP 04 259256 A (OLYMPUS OPTICAL CO LTD), 14 September 1992, * abstract * | 1,2 | |
| A | PATENT ABSTRACTS OF JAPAN vol. 017, no. 553 (P-1625), 5 October 1993 & JP 05 158154 A (MITSUBISHI RAYON CO LTD), 25 June 1993, * abstract * | 1,2 | TECHNICAL FIELDS SEARCHED (Int.Cl.6) H01L |
| A | WO 90 13146 A (EASTMAN KODAK CO) * the whole document * | 1,2 | |

The present search report has been drawn up for all claims

| Place of search | Date of completion of the search | Examiner |
|---|---|---|
| THE HAGUE | 9 March 1998 | Lina, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document